# EUROPEAN PATENT SPECIFICATION

(11) **EP 1 744 382 B1**
(45) Date of publication and mention of the grant of the patent: **19.06.2013**
(21) Application number: 06117192.2
(22) Date of filing: 14.07.2006
(51) Int. Cl.: H01L 51/50, H01L 51/52

(54) **Organic light emitting display device**
Organische lichtemittierende Vorrichtung
Dispositif organique électroluminescent

(30) Priority: 14.07.2005 KR 20050063873
(43) Date of publication of application: 17.01.2007
(73) Proprietor: Samsung Display Co., Ltd., Yongin-City, Gyeonggi-Do, 446-711 (KR)
(72) Inventor: Park, Joon-Young Samsung SDI Co., Ltd., Gyeonggi-do (KR)
(74) Representative: Hengelhaupt, Jürgen

(56) References cited:
- EP-A- 1 478 025
- EP-A2- 1 318 553
- US-A1- 2002 027 416
- US-A1- 2005 077 817

## Description

### BACKGROUND OF THE INVENTION

### 1. Field of the Invention

The present invention relates to an organic light emitting display device, and more particularly, to an organic light emitting display device having multiple emission layers, in which a charge transport layer between the emission layers is formed of an organic material to thereby enhance interfacial properties between the layers.

### 2. Description of the Related Art

An organic light emitting display device has the advantages of being able to emit light by itself, being thin and lightweight, having an ideal structure including simple parts and formed by a simple process, ensuring high picture quality and a wide viewing angle, being able to near-perfectly reproduce a moving picture, and being capable of realizing high colour purity. Further, the organic light emitting display device has electrical properties of low power consumption and low driving voltage so that the organic light emitting display device is suitable for a mobile display.

In general, the organic light emitting display device includes a substrate, a pixel electrode formed on the substrate, an organic layer comprising an emission layer (EML) formed on the pixel electrode, and a counter electrode formed on the organic layer. The organic layer may further include a hole injection layer (HIL) and a hole transport layer (HTL) between the pixel electrode and the emission layer (EML), and an electron transport layer (ETL) and an electron injection layer (EIL) between the emission layer (EML) and the counter electrode.

The organic light emitting display device with this configuration operates as follows. When a voltage is applied between the pixel electrode and the counter electrode, a hole is injected from the pixel electrode to the emission layer via the hole injection layer (HIL) and the hole transport layer (HTL), and an electron is injected from the counter electrode to the emission layer via the electron injection layer (EIL) and the electron transport layer (ETL). Then, the hole and the electron are recombined in the emission layer, thereby creating an exciton. Thus, light is emitted while the exciton is transitioned from an excited state to a ground state.

The organic light emitting display device includes an organic layer between the pixel electrode and the counter electrode to emit light, and is classified into a small molecule organic light emitting display device and a polymer organic light emitting display device according to the kind of the organic layer.

A polymer has a structure in which tens through hundreds of monomer units (i.e., repeating units) are connected to one another by a covalent bond. Therefore, the polymer is more useful for forming a thin organic layer than small molecules, and a polymer organic layer has higher impact resistance than a small molecule organic layer. Further, the polymer includes not only a monomer for transporting holes but also a monomer for transporting electrons, so that early organic light emitting display devices were manufactured by interposing only the emission layer of the polymer between the pixel electrode and the counter electrode. In the meantime, there have been attempts to apply a multilayered structure to the polymer organic light emitting display device in order to optimise driving voltage, brightness and luminous efficiency. However, when a polymer emission layer is formed by a wet process such as a spin coating method or an ink jet method, a material for the hole injection layer (HIL) or the hole transport layer (HTL) which has been formed under the emission layer may be soluble in an organic solvent used in the wet process for forming the emission layer. Therefore, the material for the hole injection layer (HIL) or the hole transport layer (HTL) must not be soluble in the organic solvent. For example, water-soluble materials such as PEDOT (poly-3,4-ethylenedioxythiophene), PANI (polyaniline) or etc. are used for the hole transport layer (HTL). However, poor interfacial properties between the water-soluble hole transport layer (HTL) and the hydrophobic emission layer causes the device to be deteriorated, thereby decreasing the lifespan of the device. Korean Patent Application No. 1997-0045389 proposes a method of increasing luminous efficiency by using a small-molecule material as a hole transport layer (HTL), wherein the small-molecule material is insoluble in a solvent capable of solving the polymer material. However, this patent is premised on that an ordinary small-molecule material cannot be used as the hole transport layer (HTL).

In an organic light emitting display device, a first electrode, a hole transport layer, a first emission layer, a charge transport layer, a second emission layer, an electron transport layer, an electron injection layer, and a second electrode are sequentially stacked on a substrate. Here, the first electrode and the second electrode may be used as a pixel electrode and a counter electrode, respectively. Further, the charge transport layer formed of inorganic material such as vanadium oxide (V₂O₅) serves to transport electrons to the first emission layer adjacent to the first electrode, and transport holes into the second emission layer adjacent to the second electrode. As the holes and the electrons are recombined in the respective emission layers, it is possible to increase luminous efficiency as much as the stacked number of the emission layers. However, the charge transport layer formed of an inorganic material such as vanadium oxide (V₂O₅) has an effect on a lower organic layer while being formed, so that processes are unstably performed. Further, a difference in layer-forming temperature between the organic layer and the inorganic layer deteriorates interfacial properties therebetween.

Document EP 1 478 025 discloses a cascaded organic electroluminescent device including a stock of a plurality of organic electroluminescent units between which a connecting unit comprising, in sequence, an n-type doped organic layer and a p-type doped organic layer is formed. The connecting unit can be formed of a stocked of Alq₃ doped /NPB doped.

Document US 2002/0027416 discloses an organic electroluminescent device comprising two light emitting layers between which a buffer layer formed of one or more layers is disposes. A NPB buffer layer is disclosed.

Document US 2005/0077817 discloses an OLED device comprising two electroluminescent layers between which a gap layer is formed, BAlq is disclosed as a gap layer.

Document EP 1 318 553 discloses an OLED device comprising a stack of a plurality of functional organic thin film layers between which a conductive thin film layer formed of organic doped layers is formed.

### SUMMARY OF THE INVENTION

The organic light emitting display device according to the present invention comprises a substrate; a first electrode formed on the substrate; a second electrode; at least two emission layers between the first electrode and the second electrode; and at least one organic charge transport layer between the emission layers. The organic charge transport layer has a stacked structure of an electron transport layer and a hole transport layer, an electron mobility and a hole mobility which are different by a factor of 100 or less, and the organic charge transport layer has a stacked structure of tris-(8-hydroxyquinoline)-aluminum (Alq3), copper phthalocyanine (CuPC) and N,N'-bis(1-naphthyl)-N,N'-diphenyl-1,1'-biphenyl-4,4'-diamine (NPB).

In other words, the present invention provides an organic light emitting display device having multiple emission layers, in which an organic charge transport layer is interposed between the emission layers to enhance interfacial properties between layers, thereby increasing luminous efficiency.

The organic light emitting display device may further comprise at least one thin film transistor between the substrate and the first electrode.

According to a preferred embodiment of the invention the charge transport layer has a HOMO ranging from 5.3 to 6.0eV and a LUMO ranging from 2.0 to 3.0eV.

Further, the organic light emitting display device may further include at least one layer of a hole injection layer, a hole transport layer, a hole blocking layer, an electron transport layer and an electron injection layer, which is preferably formed of an organic material, particularly a small molecule organic material, formed between the first electrode and the emission layer and/or between the second electrode and the emission layer. Each of these layers may be formed by a deposition method.

According to an aspect of the present invention, an organic light emitting display includes: a substrate; a first electrode formed on the substrate; a first emission layer formed on the first electrode; a first charge transport layer formed on the first emission layer, the first charge transport layer comprising an organic material, the first charge transport layer capable of transporting electrons and holes; a second emission layer formed on the first charge transport layer; and a second electrode formed on the second emission layer. Herein the HOMO and the LUMO levels as well as the electron mobility and the hole mobility may have values as described above. The organic light emitting display device may further include at least one of a second charge transport layer between the first electrode and the first emission layer and a third charge transport layer between the second emission layer and the second electrode, the second and third charge transport layers comprising a small molecule organic material. Each of the first, second and third charge transport layers may be formed of N,N'-bis(1-naphthyl)-N,N'-dipheyl-1,1'biphenyl-4,4'diamine.

According to an aspect of the present invention, an organic light emitting display device includes: a substrate; a first electrode formed on the substrate; a first emission layer formed on the first electrode; optionally at least one of a hole injection layer and a first hole transport layer between the first electrode and the first emission layer; a first electron transport layer formed on the first emission layer; a second hole transport layer formed on the first electron transport layer; a second emission layer formed on the second hole transport layer; a second electrode formed on the second emission layer; and optionally at least one of a hole blocking layer, a second electron transport layer and an electron injection layer between the second emission layer and the second electrode. In this structure the first electron transport layer comprises Alq₃ and the second hole transport layer comprises CuPC and NPB. The first electron transport layer and the second electron transport layer are preferably formed of the same material. In the same way, the first hole transport layer and the second hole transport layer are preferably formed of the same material. Further, each of the first electron transport layer and the second hole transport layer may comprise a small molecule organic material.

Further preferred embodiments of the present invention are subject matter of the depending claims.

### BRIEF DESCRIPTION OF THE DRAWINGS

A more complete appreciation of the present invention, and many of the above and other features and advantages of the present invention, will be readily apparent as the same becomes better understood by reference to the following detailed description when considered in conjunction with the accompanying drawings in which like reference symbols indicate the same or similar components, wherein:
- FIG. 1: is a cross-sectional view of a general structure of an organic light emitting display device;
- FIG. 2: is a cross-sectional view of an organic light emitting display device according to an exemplary embodiment of the present invention;
- FIG. 3: is a cross-sectional view of an organic light emitting display device according to another exemplary embodiment of the present invention; and
- FIG. 4: is a graph showing a relationship between efficiency and brightness of the organic light emitting display device according to the present invention.

### DETAILED DESCRIPTION

The present invention will now be described more fully hereinafter with reference to the accompanying drawings, in which exemplary embodiments of the invention are shown.

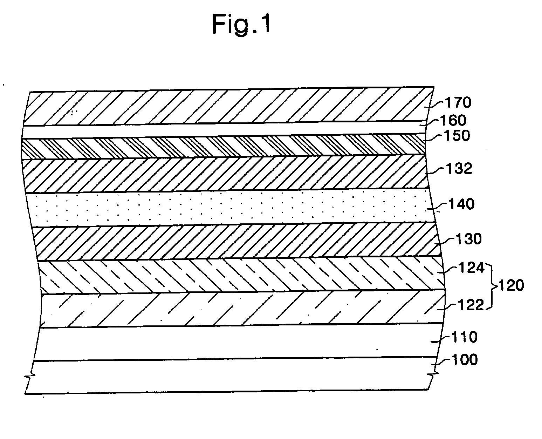

FIG. 1 is a general structure of an organic light emitting display device, in which a first electrode 110, a hole transport layer 120, a first emission layer 130, a charge transport layer 140, a second emission layer 132, an electron transport layer 150, an electron injection layer 160, and a second electrode 170 are sequentially stacked on a substrate 100. Here, the first electrode 110 and the second electrode 170 may be used as a pixel electrode and a counter electrode, respectively. Further, the charge transport layer 140 serves to transport electrons into the first emission layer 130 adjacent to the first electrode 110, and transport holes into the second emission layer 132 adjacent to the second electrode 170. As the holes and the electrons are recombined in the respective emission layers, it is possible to increase luminous efficiency as much as the stacked number of the emission layers. At this time, the first electrode 110 is formed of ITO (indium tin oxide). The hole transport layer 120 has a stacked structure of CuPc (copper phthalocyanine) 122 and NPB (N,N'-bis(1-naphthyl)-N,N'-diphenyl-1,1'biphenyl-4,4'diamine) 124. The first and second emission layers 130 and 132 are formed of Alq3/(10-(2-benzothiazolyl)-1,1,7,7-tetramethyl-2,3,6,7-tetrahydro-1H,5H,11H-[1]benzopyrano[6,7,8-ij]-quinolizin-11-one (Product name: C545T). The electron transport layer 150 is formed of Alq3 (tris-(8-hydroxyquinoline)aluminum). The charge transport layer 140 is formed of vanadium oxide (V₂O₅). The electron injection layer 160 between the electron transport layer 150 and the second electrode 170 is formed of lithium fluoride (LiF). The counter electrode 170 is formed of Al (aluminum). Preferably, a LiF layer is formed to have a thickness of about 10A not only to enhance interfacial properties between an organic layer and a reflective electrode, but also to lower a work function of aluminum used as the reflective electrode.

When the charge transport layer 140 is formed of an inorganic material such as vanadium oxide (V₂O₅), manufacturing processes are unstably performed because the inorganic layer has an effect on a lower organic layer while being formed. Further, a difference in layer-forming temperature between the organic layer and the inorganic layer deteriorates interfacial properties therebetween.

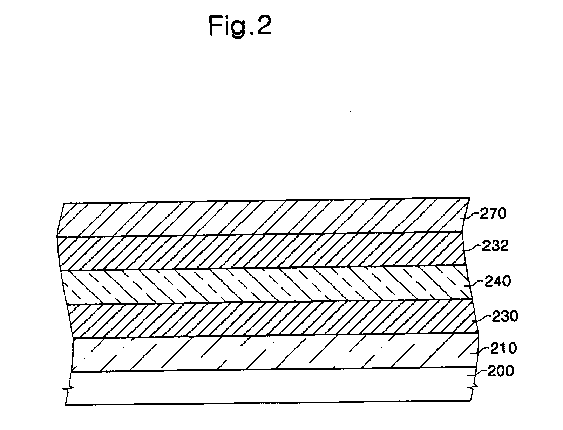

FIG. 2 is a cross-sectional view of an organic light emitting display device according to an exemplary embodiment of the present invention.

A first electrode 210, a first emission layer 230, a charge transport layer 240, a second emission layer 232 and a second electrode 270 are sequentially stacked on a substrate 200. In the case where the first electrode 210 is used as a pixel electrode, one or more thin film transistors may be further disposed between the substrate 200 and the first electrode 210. At this time, the organic light emitting display device may have a top emission structure, a bottom emission structure, or a dual emission structure.

The first electrode 210 is formed of a transparent electrode such as indium tin oxide, indium zinc oxide, etc.

The charge transport layer 240 is formed of a small molecule organic material having a highest occupied molecular orbital (HOMO) level and a lowest unoccupied molecular orbital (LUMO) level, which are proper to transport an electron and a hole to the emission layer, and having a little difference between hole mobility and electron mobility. The charge transport layer 240 allows the electron or the hole to move to the first and second emission layers 230 and 232, thereby emitting light. Preferably, the charge transport layer 240 has a HOMO level of 5.3 through 6.0eV, and a LUMO level of 2.0 through 3.0eV. Further, the electron mobility and the hole mobility of the charge transfer material are different by a factor of no more than 100. The reason why the small molecule organic material is used for the charge transport layer 240 is that it may be easily formed by a deposition method. In the case where the first electrode 210 is employed as the pixel electrode and the second electrode 270 is employed as a counter electrode, the charge transport layer 240 transports the electrons and the holes to the first emission layer 230 and the second emission layer 232, respectively.

The charge transport layer 240 has a multilayer structure. In particular, the charge transport layer 240 has a stacked structure of an electron transport layer and a hole transport layer, more precisely a stacked structure of Alq3, CuPC/NPB.

The first emission layer 230 and the second emission layer 232 may be emission layers patterned corresponding to red, green and blue, and be formed of a phosphorescent material or a fluorescent material. Further, the first emission layer 230 and the second emission layer 232 may have the same colour or different colours.

When the first emission layer 230 and the second emission layer 232 are red, a host material may include carbazole biphenyl (CBP) or 1,3-N,N-dicarbazole-benzene (mCP) and a dopant material may be a phosphorescent material including at least one selected from the group consisting of PIQIr ((acac)(bis(1-phenylisoquinoline)acetylacetonate iridium)), PQIr ((acac)(bis(1-phenylquinoline)acetylacetonate iridium)), PQIr (tris(1-phenylquinoline) iridium, and PtOEP (octaethylporphyrin platinum). Alternatively, the red emission layer may be formed of a fluorescent material such as 2-(4-biphenylyl)-5-phenyl-1,3,4-oxidiazole (PBD): tris(dibenzoylmethanido)(o-phenanthroline)europium(III) complex (Eu(DBM)3(Phen)) or perylene.

When the first emission layer 230 and the second emission layer 232 are green, a host material may include CBP or mCP, and a dopant material may be a phosphorescent material including Ir(ppy)3 (fac tris(2-phenylpyridine) iridium). Further, the green emission layer may be formed of a fluorescent material such as Alq3(tris(8-hydroxylquinoline)aluminum).

When the first emission layer 230 and the second emission layer 232 are blue, they may be formed of a fluorescent material because the optical properties of the blue emission layer are unstable when the blue emission layer is formed of a phosphorescent material. The fluorescent material may include one selected from the group consisting of 4,4-bis-(2,2-diphenyl-vinyl)-biphenyl (DPVBi), spiro-DPVBi, spiro-sexiphenyl (spiro-6P), DSB (distyrylbenzene), DSA (distyryl arylene), PFO (poly dioctyl-fluorene)-based polymer and PPV (polyphenylene vinylene)-based polymer.

The first emission layer 230 and the second emission layer 232 may be formed in each unit pixel area by a laser induced thermal imaging method or a vacuum deposition method using a fine metal mask.

The second electrode 270 may be formed of a metal material having a relatively low work function. For example, the metal material may include Al, MgAg, Ca, MgCa, etc.

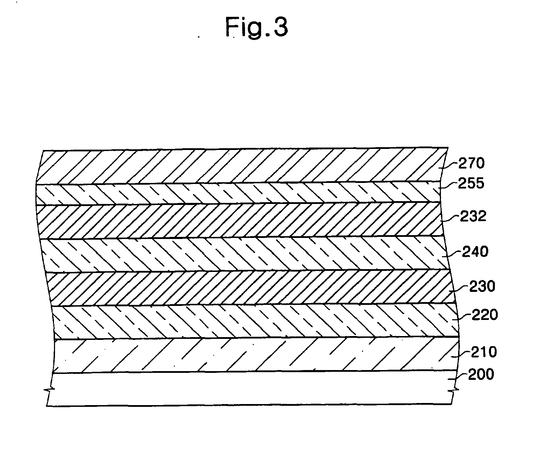

FIG. 3 is a cross-sectional view of an organic light emitting display device according to another exemplary embodiment of the present invention.

Referring to FIG. 3, a first electrode 210; a hole transport and/or injection layer 220; a first emission layer 230; a charge transport layer 240; a second emission layer 232; at least one layer 255 of a hole blocking layer, an electron injection layer and an electron transport layer; a second electrode 270 are sequentially stacked on a substrate 200. In FIG. 3, the hole transport and/or injection layer 220 is interposed between the first electrode 210 and the first emission layer 230, and the at least one layer 255 of the hole blocking layer, the electron injection layer and the electron transport layer is interposed between the second electrode 270 and the second emission layer 232, but not limited thereto. Alternatively, either the hole transport and/or injection layer 220 or the at least one layer 255 of the hole blocking layer, the electron injection layer and the electron transport layer may be provided.

The hole transport and/or injection layer 220 may have a monolayer of NPB or a stacked structure of CuPC/NPB.

The hole blocking layer, the electron transport layer and the electron injection layer 255 are formed of a publicly known material. The hole injection layer, the hole transport layer, the hole blocking layer, the electron transport layer and the electron injection layer may be formed of a small molecule material, and one or more layers among them may be formed by a deposition method.

Below, exemplary embodiments of the present invention will be described to facilitate understanding of the present invention, but the present invention is not limited to the following exemplary embodiments.

### <Exemplary embodiment 1> (not encompassed by the present invention)

ITO was patterned as a first electrode on a substrate, and a pixel area was defined. Then, NPB as a first charge transport layer was formed to a thickness of 600 Å on the first electrode by a deposition method. Then, a stacked structure of Alq3 and C545T for a green emission layer was formed to a thickness of 300 Å as the first emission layer on the first charge transport layer. NPB as a second charge transport layer was formed to a thickness of 300 Å on the first emission layer. Then, a stacked structure of Alq3 and C545T, i.e.,10-(2-benzothiazolyl)-1,1,7,7-tetramethyl-2,3,6,7-tetrahydro-1H,5H,11H-[1]benzopyrano[6,7,8-ij]-quinolizin-11-one was formed to a thickness of 300 Å as a second emission layer on the second charge transport layer. Then, NPB was formed to a thickness of 100 Å as a third charge transport layer on the second emission layer. Then, a second electrode was formed of aluminum on the third charge transport layer. At this time, because the second electrode was formed of aluminum, LiF was formed to a thickness of 10 Å in consideration of interfacial properties between the third charge transport layer and the second electrode.

### <Exemplary embodiment 2>

ITO was patterned as a first electrode on a substrate, and a pixel area was defined. Then, CuPC and NPB were formed to a thickness of 400 Å and a thickness of 300 Å, respectively, as a first hole transport layer on the first electrode. Then, a stacked structure of Alq3 and C545T for a green emission layer was formed to a thickness of 300 Å as a first emission layer on the first hole transport layer. Then, Alq3 was formed to a thickness of 200 Å as a first electron transport layer on the first emission layer. Then, CuPC and NPB were formed to a thickness of 300 Å, respectively, as a second hole transport layer on the first electron transport layer. Then, a stacked structure of Alq3 and C545T was formed to a thickness of 300 Å as a second emission layer on the second hole transport layer. Then, Alq3 was formed to a thickness of 200 Å as a second electron transport layer on the second emission layer. Then, aluminum was formed as a second electrode on the second electron transport layer. At this time, because the second electrode was formed of aluminum, LiF was formed to a thickness of 10 Å in consideration of interfacial properties between the second electron transport layer and the second electrode.

### <Comparative example 1>

A first electrode, a hole transport layer, an emission layer, an electron transport layer and a second electrode are sequentially stacked on the substrate, which are formed by the same method but different in the number of emission layers compared to < Exemplary embodiment 1>.

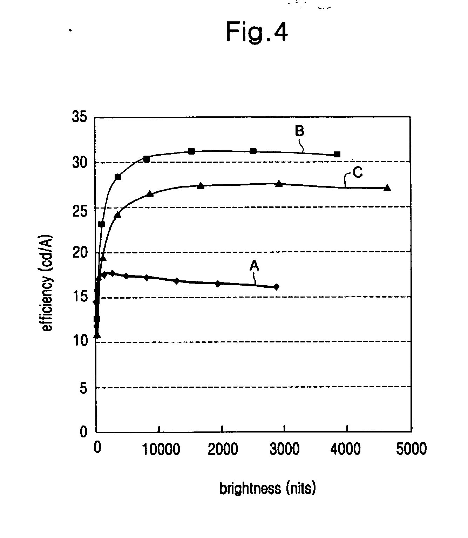

FIG. 4 is a graph showing a relationship between efficiency and brightness of an organic light emitting display device according to <Exemplary embodiment 1>, <Exemplary embodiment 2>, and <Comparative example 1>.

Referring to FIG. 4, the organic light emitting display devices having multiple emission layers according to <Exemplary embodiment 2> (B) and <Exemplary embodiment 1> (C) are excellent in luminous efficiency compared to the organic light emitting display device having a single emission layer according to <Comparative example 1> (A). Further, even though the organic light emitting display device according to <Exemplary embodiment 2> (B) has better luminous efficiency than that of <Exemplary embodiment 1> (C), but a simple structure of <Exemplary embodiment 1> is more preferable in terms of the manufacturing process.

Thus, the organic light emitting display device having the multiple emission layers needs a driving voltage increased by 3 through 4V, but the luminous efficiency increases as much as the stacked number of the emission layers.

As described above, the present invention provides an organic light emitting display device having multiple emission layers, in which a small molecule organic material is interposed between emission layers to enhance interfacial properties between layers, thereby increasing luminous efficiency.

## Claims

1. An organic light emitting display device, comprising:
a substrate (200);
a first electrode (210) formed on the substrate (200);
a second electrode (270);
at least two emission layers (230, 232) between the first electrode (210) and the second electrode (270); and
at least one organic charge transport layer (240) between the emission layers (230, 232),
wherein the organic charge transport layer (240) has a stacked structure of an electron transport layer and a hole transport layer,
the organic charge transport layer (240) has an electron mobility and a hole mobility which are different by a factor of 100 or less, and
**characterized in that**
the organic charge transport layer (240) has a stacked structure of tris-(8-hydroxyquinoline)aluminum (Alq₃), copper phthalocyanine (CuPC) and N,N'-bis(1-naphthyl)-N,N'-diphenyl-1,1'-biphenyl-4,4'-diamine (NPB).

2. The organic light emitting display device according to claim 1, further comprising at least one thin film transistor between the substrate (200) and the first electrode (210).

3. The organic light emitting display device according to one of the preceding claims, further comprising at least one layer (220) of a hole injection layer and a hole transport layer, and/or at least one layer (255) of a hole blocking layer, an electron transport layer and an electron injection layer, the at least one layer (220, 255) being disposed between the first electrode (210) and the second electrode (270).

4. The organic light emitting display device according to claim 3, wherein the at least one layer (220) of the hole injection layer and the hole transport layer, and/or at least one layer (255) of the hole blocking layer, the electron transport layer and the electron injection layer is formed of a small molecule organic material.

5. The organic light emitting display device according to one of claim 3 or 4, wherein the at least one layer (220) of the hole injection layer and the hole transport layer is interposed between the first electrode (210) and the first emission layer (230).

6. The organic light emitting display device according to one of claims 3 to 5, wherein the at least one layer (220) of the hole injection layer and the hole transport layer may comprise a monolayer of NPB or a stacked structure of CuPC and NPB.

7. The organic light emitting display device according to one of claims 3 to 6, wherein the at least one layer (255) of the hole blocking layer, the electron injection layer and the electron transport layer is interposed between the second electrode (270) and the second emission layer (232).

## Patentansprüche

1. Organische lichtemittierende Anzeige, aufweisend:
ein Substrat (200);
eine erste Elektrode (210), die auf dem Substrat (200) ausgebildet ist;
eine zweite Elektrode (270);
zumindest zwei Emissionsschichten (230, 232) zwischen der ersten Elektrode (210) und der zweiten Elektrode (270); und
zumindest eine organische Ladungstransportschicht (240) zwischen den Emissionsschichten (230, 232),
wobei die organische Ladungstransportschicht (240) eine Stapelstruktur aus einer Elektronentransportschicht und einer Lochtransportschicht aufweist, und
wobei die organische Ladungstransportschicht (240) eine Elektronenbeweglichkeit und eine Löcherbeweglichkeit aufweist, die sich um einen Faktor von 100 oder weniger voneinander unterscheiden,
**dadurch gekennzeichnet, dass**
die organische Ladungstransportschicht (240) eine Stapelstruktur aus Tris(8-Hydroxychinolin)-Aluminium (Alq₃), Kupferphthalocyanin (CuPc) und N,N'-bis(1-naphthyl)-N,N'-diphenyl-1,1'-biphenyl-4,4'-diamin (NPB) aufweist.

2. Organische lichtemittierende Anzeige nach Anspruch 1, weiterhin aufweisend zumindest einen Dünnfilmtransistor zwischen dem Substrat (200) und der ersten Elektrode (210).

3. Organische lichtemittierende Anzeige nach einem der vorhergehenden Ansprüche, weiterhin aufweisend zumindest eine Schicht (220) einer Lochinjektionsschicht und einer Lochtransportschicht und/oder zumindest eine Schicht (255) einer Lochblockierschicht, einer Elektronentransportschicht und einer Elektroneninjektionsschicht, wobei die zumindest eine Schicht (220, 255) zwischen der ersten Elektrode (210) und der zweiten Elektrode (270) angeordnet ist.

4. Organische lichtemittierende Anzeige nach Anspruch 3, wobei die zumindest eine Schicht (220) der Lochinjektionsschicht und der Lochtransportschicht und/oder die zumindest eine Schicht (255) der Lochblockierschicht, der Elektronentransportschicht und der Elektroneninjektionsschicht aus einem niedermolekularen organischen Material ausgebildet ist.

5. Organische lichtemittierende Anzeige nach einem von Anspruch 3 oder 4, wobei die zumindest eine Schicht (220) der Lochinjektionsschicht und der Lochtransportschicht zwischen der ersten Elektrode (210) und der ersten Emissionsschicht (230) angeordnet ist.

6. Organische lichtemittierende Anzeige nach einem der Ansprüche 3 bis 5, wobei die zumindest eine Schicht (220) der Lochinjektionsschicht und der Lochtransportschicht eine Monoschicht aus NPB oder eine Stapelstruktur aus CuPC und NPB aufweisen kann.

7. Organische lichtemittierende Anzeige nach einem der Ansprüche 3 bis 6, wobei die zumindest eine Schicht (255) der Lochblockierschicht, der Elektroneninjektionsschicht und der Elektronentransportschicht zwischen der zweiten Elektrode (270) und der zweiten Emissionsschicht (232) angeordnet ist.

## Revendications

1. Dispositif d'affichage électroluminescent organique, comprenant :
un substrat (200) ;
une première électrode (210) formée sur le substrat (200) ;
une deuxième électrode (270) ;
au moins deux couches d'émission (230, 232) entre la première électrode (210) et la deuxième électrode (270) ; et
au moins une couche organique de transport de charges (240) entre les couches d'émission (230, 232),
où la couche organique de transport de charges (240) a une structure empilée d'une couche de transport d'électrons et d'une couche de transport de trous, et
la couche organique de transport de charges (240) a une mobilité d'électrons et une mobilité de trous qui diffèrent d'un facteur de 100 ou moins,
**caractérisé en ce que**
la couche organique de transport de charges (240) a une structure empilée de tris-(8-hydroxyquinoléine) aluminium (Alq₃), de phtalocyanine de cuivre (CuPC) et de N,N'-bis(1-naphthyl)-N,N'-diphényl-1,1'-biphényl-4,4'-diamine (NPB).

2. Dispositif d'affichage électroluminescent organique selon la revendication 1, comprenant en outre au moins un transistor à couches minces entre le substrat (200) et la première électrode (210).

3. Dispositif d'affichage électroluminescent organique selon l'une des revendications précédentes, comprenant en outre au moins une couche (220) d'une couche d'injection de trous et d'une couche de transport de trous, et/ou au moins une couche (255) d'une couche de blocage de trous, d'une couche de transport d'électrons et d'une couche d'injection d'électrons, l'au moins une couche (220, 255) étant disposée entre la première électrode (210) et la deuxième électrode (270).

4. Dispositif d'affichage électroluminescent organique selon la revendication 3, dans lequel l'au moins une couche (220) de la couche d'injection de trous et de la couche de transport de trous, et/ou l'au moins une couche (255) de la couche de blocage de trous, de la couche de transport d'électrons et de la couche d'injection d'électrons est/sont formée(s) d'un matériau organique constitué de petites molécules.

5. Dispositif d'affichage électroluminescent organique selon l'une des revendications 3 et 4, dans lequel l'au moins une couche (220) de la couche d'injection de trous et de la couche de transport de trous est interposée entre la première électrode (210) et la première couche d'émission (230).

6. Dispositif d'affichage électroluminescent organique selon l'une des revendications 3 à 5, dans lequel l'au moins une couche (220) de la couche d'injection de trous et de la couche de transport de trous peut comprendre une monocouche de NPB ou une structure empilée de CuPC et de NPB.

7. Dispositif d'affichage électroluminescent organique selon l'une des revendications 3 à 6, dans lequel l'au moins une couche (255) de la couche de blocage de trous, de la couche d'injection d'électrons et de la couche de transport d'électrons est interposée entre la deuxième électrode (270) et la deuxième couche d'émission (232).
